(19) Europäisches Patentamt / European Patent Office / Office européen des brevets

(11) **EP 2 732 515 B1**

(12) **FASCICULE DE BREVET EUROPEEN**

(45) Date de publication et mention
de la délivrance du brevet:
**13.05.2015 Bulletin 2015/20**

(21) Numéro de dépôt: **12748730.4**

(22) Date de dépôt: **11.07.2012**

(51) Int Cl.:
**H01S 5/10** *(2006.01)*      **H01S 5/02** *(2006.01)*

(86) Numéro de dépôt international:
**PCT/FR2012/000286**

(87) Numéro de publication internationale:
**WO 2013/007896 (17.01.2013 Gazette 2013/03)**

(54) **DISPOSITIF LASER À CAVITÉ EN FORME DE BOUCLE APTE À ÊTRE FONCTIONNALISÉE**

LASERVORRICHTUNG MIT RINGRESONATOR DER FUNKTIONALISIERT WERDEN KANN

LASER DEVICE HAVING A RING CAVITY SUITABLE TO BE FUNCTIONALIZED

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **11.07.2011 FR 1102181**

(43) Date de publication de la demande:
**21.05.2014 Bulletin 2014/21**

(73) Titulaire: **Commissariat à l'Énergie Atomique
et aux Énergies Alternatives
75015 Paris (FR)**

(72) Inventeurs:
• **BEN BAKIR, Badhise**
F-38590 Brézins (FR)
• **DESCOS, Antoine**
F-38000 Grenoble (FR)
• **FEDELI, Jean-Marc**
F-38120 Saint-Egréve (FR)
• **OLIVIER, Nicolas**
F-38470 Têche (FR)

(74) Mandataire: **Talbot, Alexandre et al
Cabinet Hecké
Europole
10, rue d'Arménie - BP 1537
38025 Grenoble Cedex 1 (FR)**

(56) Documents cités:
EP-A1- 2 337 167       WO-A2-2004/088801
FR-A1- 2 290 059       GB-A- 2 391 692
US-A1- 2003 219 045    US-A1- 2009 028 492
US-A1- 2009 116 523    US-A1- 2010 246 617

• DE ALEXANDER W. FANG: "Integrated AlGaInAs-silicon evanescent race track Laser and photodectector", OPTIC EXPRESS, vol. 15, 5 mars 2007 (2007-03-05), pages 2315-2322, XP002683063, cité dans la demande
• ROELKENS G ET AL: "Hybrid silicon lasers", PROCEEDINGS OF SPIE, SPIE, US, vol. 7942, 26 janvier 2011 (2011-01-26), pages 79420D/1-9, XP009149188, ISSN: 0277-786X, DOI: 10.1117/12.880089
• LIU LIU ET AL: "Low-power electro-optical switch based on a iii-v microdisk cavity on a silicon-on-insulator circuit", COMMUNICATIONS AND PHOTONICS CONFERENCE AND EXHIBITION, 2009. ACP 2009. ASIA, IEEE, PISCATAWAY, NJ, USA, 2 novembre 2009 (2009-11-02), pages 1-6, XP031623191, ISBN: 978-1-55752-877-3
• MINYU YAO ET AL: "Theoretical analyses on short-term stability of semiconductor fiber ring lasers", IEEE JOURNAL OF QUANTUM ELECTRONICS, IEEE SERVICE CENTER, PISCATAWAY, NJ, USA, vol. 39, no. 10, 1 octobre 2003 (2003-10-01), pages 1260-1265, XP011101711, ISSN: 0018-9197, DOI: 10.1109/JQE.2003.817668
• BEN BAKIR B ET AL: "Hybrid Si/III V lasers with adiabatic coupling", GROUP IV PHOTONICS (GFP), 2011 8TH IEEE INTERNATIONAL CONFERENCE ON, IEEE, 14 septembre 2011 (2011-09-14), pages 169-171, XP032066867, DOI: 10.1109/GROUP4.2011.6053752 ISBN: 978-1-4244-8338-9

## Description

## Domaine technique de l'invention

L'invention est relative à un dispositif laser comportant :

- un amplificateur comprenant une hétérostructure de type III-V agencée pour générer des photons,
- un guide d'onde, formant une boucle, couplé optiquement à l'amplificateur.

## État de la technique

La photonique sur silicium (CMOS) adresse de nombreux domaines d'application tels que les interconnexions optiques dans les circuits intégrés, les télécommunications, la biophotonique, etc.

L'intégration de matériaux de type III-V avec du silicium est à présent considérée comme une approche permettant d'apporter des caractéristiques d'émission jusqu'alors inaccessibles au silicium.

En général, un dispositif laser peut comporter un amplificateur à hétérostructure de type III-V couplé optiquement à un guide d'onde en silicium. La cavité résonnante de ce dispositif est formée par des miroirs disposés au niveau du guide d'onde de part et d'autre de l'amplificateur.

Le document « Integrated AlGaInAs-silicon evanescent race track Laser and photodectector » de Alexander W. Fang publié le 5 mars 2007 dans le volume 15 numéro 5 de Optic Express pages 2315 à 2322 décrit un dispositif laser utilisant une cavité de type anneau/boucle. Dans ce document, et comme illustré à la figure 1, le guide d'onde 2 en silicium se présente sous la forme d'un anneau couplé sur toute sa longueur avec un amplificateur 1 formé par une hétérostructure de type III-V, elle aussi sous la forme d'anneau, et reportée sur ledit anneau formant le guide d'onde 2 en silicium. Le guide d'onde 2 est couplé optiquement par couplage codirectionnel à un guide d'onde de sortie 3 permettant d'extraire une onde laser. Le guide d'onde 3 de sortie est aussi toujours recouvert par l'hétérostructure III-V.

Ce type de dispositif laser est limité à générer une onde laser, et à l'envoyer vers un guide d'onde de sortie. De plus, son gain modal est relativement faible

La demande de brevet US 2009/028492 décrit un résonateur optique comportant une structure laser amplificatrice, et plusieurs segments de guide d'ondes optiques relié entre eux avec des miroirs à réflexion interne totale pour former une boucle fermée. La structure laser comporte un empilement de couches en matériau semi-conducteur III-V.

## Objet de l'invention

L'objet de l'invention consiste à réaliser un dispositif laser compact, performant et permettant une fonctionnalisation dudit guide d'onde.

Ce but est atteint en ce que l'amplificateur est disposé en regard du guide d'onde uniquement au niveau d'un premier tronçon dudit guide d'onde et en ce qu'il comporte un premier transformateur de mode et un second transformateur de mode, chacun formé dans le guide d'onde à une extrémité respective du premier tronçon de sorte à réaliser le couplage optique entre le guide d'onde et l'amplificateur. La largeur du premier tronçon peut être inférieure, sur au moins une portion de ce dernier, à la largeur dudit guide d'onde de part et d'autre dudit premier tronçon, le rétrécissement engendré délimitant les premier et second transformateurs de mode.

Selon une fonctionnalisation du dispositif, le guide d'onde comporte un deuxième tronçon distinct du premier tronçon, et formant un micro-résonateur (17) pour réaliser un filtrage de mode.

Avantageusement, le micro-résonateur peut comporter un système de modulation de son indice effectif.

Selon une variante, le deuxième tronçon a la forme d'un anneau ou d'un disque couplé optiquement à des troisième et quatrième tronçons du guide d'onde distincts du premier tronçon.

Avantageusement, les deuxième, troisième et quatrième tronçons sont formés dans un même plan ou les troisième et quatrième tronçons sont formés dans un même plan, parallèle à un plan décalé comportant le deuxième tronçon.

Selon une mise en oeuvre particulière, le micro-résonateur est un cristal photonique.

Selon un mode de réalisation, l'amplificateur a une forme de boucle, une seule portion de la boucle de l'amplificateur étant disposée en regard du premier tronçon du guide d'onde.

Selon une mise en oeuvre, le guide d'onde est couplé à un amplificateur optique à semi-conducteur sur un tronçon du guide d'onde distinct du premier tronçon.

## Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :

- la figure 1 illustre un dispositif laser sous forme d'anneau de l'art antérieur,
- la figure 2 illustre une mise en oeuvre d'un dispositif laser selon l'invention vu de dessus,
- la figure 3 illustre une vue partielle de côté du dispositif de la figure 2 centrée sur l'amplificateur,
- la figure 4 illustre une vue de dessus de la figure 3,
- la figure 5 illustre le principe de fonctionnement d'un transformateur de mode,
- la figure 6 illustre une mise en oeuvre particulière du premier tronçon du guide d'onde avec implémentation de deux transformateurs de mode,

- la figure 7 illustre une variante de la figure 4 dans laquelle le premier tronçon comporte une section en forme de créneau,
- la figure 8 illustre une vue en coupe selon A-A de la figure 7,
- la figure 9 illustre une vue en trois dimensions du premier tronçon de la figure 7,
- la figure 10 illustre un dispositif laser équipé d'un micro-résonateur additionnel,
- les figures 11 à 15 illustrent différentes mises en oeuvre du micro-résonateur,
- la figure 16 illustre une variante de réalisation du dispositif laser,
- la figure 17 illustre un dispositif laser comprenant un amplificateur optique à semi-conducteur,
- la figure 18 illustre le dispositif laser muni d'un guide d'onde de sortie couplé à la cavité laser,
- la figure 19 illustre une variante d'un micro-résonateur.

## Description de modes préférentiels de réalisation

Le dispositif laser décrit ci-après diffère de l'art antérieur notamment en ce qu'il comporte des transformateurs de modes formés dans le guide d'onde de sorte à réaliser un dispositif plus compact ayant une meilleure efficacité de couplage et permettant une fonctionnalisation dudit guide d'onde.

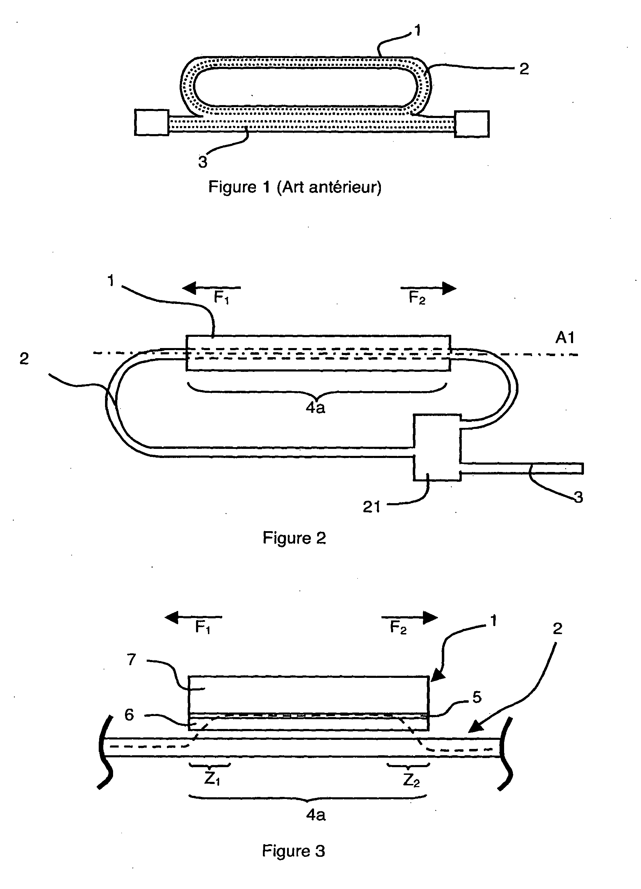

Par convention, sur un circuit optique réalisé dans un plan donné, il est défini des états de polarisation TE (pour « transverse electric » en anglais) et TM (pour « transverse magnetic » en anglais) tel que dans l'état TE le champ électrique est parallèle au plan du circuit, alors que le champ magnétique est perpendiculaire au plan du circuit, et dans l'état TM le champ magnétique est parallèle au plan du circuit tandis que le champ électrique est perpendiculaire au plan du circuit. En fait, dans le dispositif décrit ci-après, il faudra, de préférence, implicitement considérer un état de polarisation quasi-TE, c'est-à-dire que le champ électrique est très majoritairement polarisé selon sa direction TE. Ainsi, la structure du dispositif telle que décrite permettra préférentiellement un couplage du mode TE ou quasi-TE d'une onde optique. La figure 2 illustre un dispositif laser comprenant un amplificateur 1 muni d'une hétérostructure de type III-V, l'hétérostructure étant agencée pour générer des photons, générant ainsi une onde optique apte à se propager et à être amplifié dans l'amplificateur 1. Une onde optique peut être composée d'un ou plusieurs modes optiques.

Le dispositif laser comporte en outre un guide d'onde 2 couplé optiquement à l'amplificateur 1. Le couplage optique entre l'amplificateur 1 et le guide d'onde 2 permet aux photons générés et/ou amplifiés dans l'amplificateur 1 de passer de l'amplificateur 1 au guide d'onde 2, vice-versa, sous la forme d'une onde optique. L'amplificateur 1 est disposé en regard du guide d'onde 2 uniquement au niveau d'un premier tronçon 4a dudit guide d'onde 2. Sur l'exemple de la figure 2, le guide d'onde 2 et l'amplificateur 1 sont disposés dans des plans décalés, c'est-à-dire que l'amplificateur 1 est disposé au-dessus du guide d'onde 2, et que le guide d'onde 2 et l'amplificateur 1 comportent des faces proximales permettant à l'onde optique de passer de l'un à l'autre. Autrement dit, la distance séparant le guide d'onde 2 et l'amplificateur 1 est telle que le couplage optique est favorisé. La distance de séparation peut être comprise entre 5nm et 500nm. En fait, plus l'espacement est grand, plus la longueur de couplage est grande, tout dépend donc de l'application visée. Un dispositif long pourra émettre beaucoup de puissance, et un dispositif court émettra moins de puissance mais sera plus compact et moins consommateur d'énergie. Le guide d'onde 2 forme une boucle permettant de définir la cavité du laser en forme de boucle. Ainsi, les photons parcourent la boucle selon le sens des aiguilles d'une montre, et/ou inversement, sans avoir à changer de sens de propagation, et sont amplifiés, c'est-à-dire démultipliés, de manière cohérente à chaque tour par l'amplificateur 1.

De préférence, au niveau du premier tronçon 4a, l'amplificateur 1 et le guide d'onde 2 sont rectilignes, et allongés dans les sens de propagation de l'onde optique (flèches $F_1$ et $F_2$). Les axes longitudinaux du guide d'onde 2 et de l'amplificateur 1 sont parallèles selon l'axe A1 représenté à la figure 2.

Par hétérostructure de type III-V, on entend l'utilisation dans cette hétérostructure de matériaux pouvant être choisis dans la liste non exhaustive suivante : InP, GaAs, InGaAlAs, InGaAsP, AlGaAs, InAsP.

La figure 3 illustre l'hétérostructure d'un tel amplificateur 1, couplé optiquement au guide d'onde 2, aussi appelé milieu à gain. Le chemin de l'onde optique est représenté par les pointillés. L'hétérostructure peut comporter un empilement comprenant une couche munie d'éléments quantiques 5 prise en sandwich entre une première couche 6 dopée (proximale du guide d'onde 2), de préférence dopée N, et une seconde couche 7 dopée, de préférence dopée P. La première couche 6 dopée, lorsqu'elle est dopée N, peut comporter un matériau choisi, pour l'essentiel, parmi InP, GaAs, InGaAsP, InGaAlAs, AlGaAs, InAsP. La seconde couche 7 dopée, lorsqu'elle est dopée P, peut comporter un matériau choisi parmi InP, GaAs, InGaAsP, InGaAlAs, AlGaAs, InAsP. Autrement dit, les matériaux utilisés pour la première couche 6 et la seconde couche 7 peuvent être les mêmes, seul le dopage change. Bien entendu, le dopage peut être inversé, c'est-à-dire que la première couche 6 dopée peut être dopée P, et la seconde couche 7 dopée peut être dopée N. La couche d'éléments quantiques 5 peut comporter des puits quantiques, ou des boîtes quantiques, permettant la recombinaison de trous et d'électrons pour former des photons, et ainsi générer l'onde optique au niveau de l'amplificateur 1. Les éléments quantiques peuvent comporter un matériau tels que InP, GaAs, InGaAsP, InGaAlAs, AlGa, As, InAsP. Pour compléter l'amplificateur 1, les première et seconde couches 6, 7 sont classiquement en contact électrique avec des électrodes associées (non représentées) permettant de générer du courant, et de réaliser le pompage électrique de l'amplificateur 1.

Sur la figure 3, certains photons générés peuvent se déplacer selon la flèche $F_1$, et d'autres photons générés peuvent se déplacer selon la flèche $F_2$.

De préférence, le guide d'onde 2 et l'amplificateur 1 sont séparés par une couche diélectrique (non représentée pour des raisons de clarté) à la fois en contact avec le guide d'onde 2 et l'amplificateur 1 au moins au niveau du premier tronçon 4a. Au niveau du premier tronçon 4a, le guide d'onde 2 peut être recouvert par le matériau diélectrique de la couche. Le ou les matériaux diélectriques constituant la couche séparant le guide d'onde 2 et l'amplificateur 1 ont, de préférence, un indice de réfraction faible, par exemple compris entre 1,4 (indice proche de la silice) et 2,2 (indice proche de $Si_3N_4$ ou $Al_2O_3$). La couche de diélectrique permet avantageusement de faciliter la réalisation du dispositif laser et d'améliorer l'efficacité du couplage entre l'amplificateur 1 et le guide d'onde 2. On parle d'indice de réfraction lorsque l'on considère une onde optique qui se propage dans un matériau infini en trois dimensions, sa vitesse de propagation est la vitesse de la lumière divisée par l'indice de réfraction.

L'indice de réfraction est à différencier de l'indice effectif. En effet, on parle d'indice effectif lorsque l'on considère une onde optique se propageant dans une géométrie particulière, par exemple un guide d'onde. Dans une telle géométrie, le champ est altéré, ce qui signifie que la vitesse de propagation de l'onde est aussi altérée. La vitesse de propagation est égale à la vitesse de la lumière sur l'indice effectif. Pour calculer l'indice effectif, on utilise la méthode des éléments finis.

Le couplage optique entre le premier tronçon 4a et l'amplificateur 1 peut être réalisé grâce à deux zones de couplage $Z_1$ et $Z_2$ (figure 3) formées, de préférence, aux extrémités longitudinales du premier tronçon 4a. Chaque zone de couplage $Z_1$, $Z_2$ a une longueur, selon l'axe longitudinal du guide d'onde qui est un multiple impair de la longueur de couplage $L_c$, et de préférence égale à $L_c$.

L'efficacité de couplage optimal (F) dans le cadre d'un couplage direct (c'est-à-dire sans utilisation de transformateurs de mode tels que décrits ci-après) est définie comme étant la fraction de puissance transmise d'un premier guide vers un second guide (ici le guide d'onde 2 vers l'amplificateur 1 et inversement) au bout d'une distance caractéristique dite longueur de couplage $L_c$ :

$$F = 1 - \left( \frac{\Delta n_{eff,L}}{\Delta n_{eff,S}} \right)^2 \quad (1),$$

avec

$$L_c = \frac{\lambda}{2\Delta n_{eff,S}} \quad (2),$$

où:

$\lambda$ : est la longueur d'onde d'opération.

$\Delta n_{eff,\,L}$ : est la différence entre les indices effectifs des modes supportés par les premier et second guides en l'absence de couplage (les guides sont pris individuellement). Ces modes guidés sont appelés modes locaux.

$\Delta n_{eff,S}$ : est la différence entre les indices effectifs des modes supportés par la structure de couplage comprenant les deux guides juxtaposés. Ces deux supermodes sont par construction de symétrie opposée. On parlera alors de supermodes symétrique et antisymétrique. Cette quantité physique est dépendante de la distance qui sépare les deux guides. Elle conditionne la longueur de couplage $L_c$ ainsi que le taux de puissance transférée.

Un mode d'une onde optique correspond à une configuration spatiale du champ électromagnétique tel que défini précédemment (composante TE ou quasi-TE). Typiquement, une onde optique comporte une pluralité de modes. Par monomode, on entend que seul un des modes est couplé optiquement. Lorsque le système est couplé comme dans le cas du laser, on parle de supermodes. Les modes propres, aussi appelés modes locaux, sont ceux du guide d'onde 2 et de l'amplificateur 1 pris individuellement. Les supermodes sont des combinaisons linéaires des modes locaux.

À noter que le transfert de puissance d'un guide à l'autre est un processus harmonique et donc réversible. En considérant une puissance nominale $P_0$ injectée dans le premier guide, la puissance collectée, ou transmise, dans le second guide à la position z s'exprime de la façon suivante :

$$P_{1\rightarrow 2}(z) = P_0 \cdot F \sin^2 \left( \frac{\pi}{2L_c} \cdot z \right) \quad (3)$$

On remarquera d'après la relation (3) que le transfert de puissance du premier guide vers le second guide est optimal pour des multiples impairs de la longueur caractéristique de couplage.

Dans l'art antérieur, le mode optique de l'onde est principalement confiné dans le guide d'onde en silicium au détriment du gain apporté par l'hétérostructure III-V. En effet, une partie infime du mode optique recouvre les puits quantiques.

Dans le présent dispositif laser, il est préférable de minimiser la longueur de recouvrement entre l'amplificateur 1 et le guide d'onde 2 pour limiter la longueur du premier tronçon 4a de sorte à laisser libre d'accès d'autres tronçons du guide d'onde 2, distincts du premier tronçon, pour les fonctionnaliser.

Ainsi, par rapport à l'art antérieur, il est possible d'allonger le guide d'onde 2 de sorte à permettre un recouvrement suffisant entre l'amplificateur 1 et le guide d'onde 2 pour assurer un bon couplage optique tout en laissant en partie libre le guide d'onde pour le fonctionaliser.

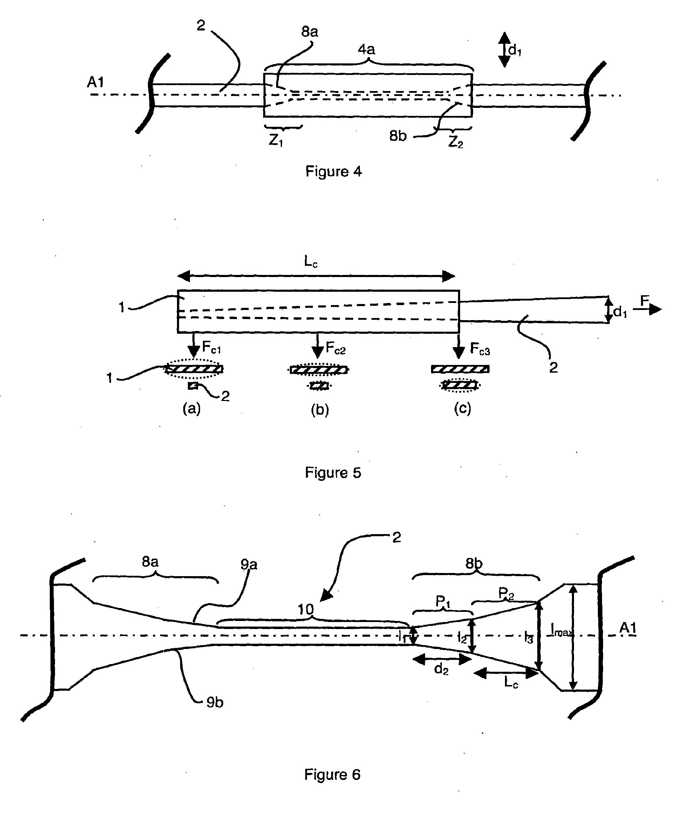

Selon une mise en oeuvre permettant de limiter la longueur du premier tronçon 4a, et donc du guide d'onde 2, illustrée à la figure 4, le dispositif laser comporte un premier transformateur de mode 8a et un second transformateur de mode 8b. Ces derniers 8a, 8b sont chacun formé dans le guide d'onde 2 à une extrémité respective du premier tronçon 4a du guide d'onde 2 de sorte à réaliser le couplage optique. Un transformateur de mode 8a, 8b permet de former au moins une zone de couplage $Z_1$, $Z_2$ telle qu'évoquée ci-dessus pour transférer progressivement, et de manière optimale, le mode de l'onde optique confiné dans l'amplificateur 1 vers le guide d'onde 2, et vice-versa. Avantageusement, les transformateurs de mode 8a et 8b sont formés uniquement dans le guide d'onde 2, permettant ainsi de faciliter la réalisation du dispositif laser, et de conserver un amplificateur performant en puissance. Les transformateurs de mode permettent alors de réaliser un dispositif plus compact que dans l'art antérieur avec une efficacité de couplage supérieure à 95%. De plus, ce couplage permet de profiter au maximum du gain des puits quantiques de l'hétérostructure contrairement à l'art antérieur.

Un transformateur de mode 8a, 8b permet de s'affranchir des contraintes sur les dimensionnements du guide d'onde 2 et de l'amplificateur 1 pour optimiser le couplage. En effet, afin de coupler optiquement de manière la plus efficace possible le guide d'onde 2 avec l'amplificateur 1, il est possible de réaliser ces deux derniers avec des indices effectifs identiques (couplage direct). Cependant, une telle réalisation implique un alignement et un dimensionnement parfait difficilement réalisables.

En fait, dans le cas d'un couplage direct (sans transformateurs de mode) où la largeur du guide d'onde est invariante selon l'axe de propagation A1, il faut que les indices effectifs soient rigoureusement identiques pour obtenir un couplage optique de l'onde de 100%, ce qui pose une contrainte sur la définition de la largeur du guide d'onde 2 et de l'amplificateur 1, au niveau du premier tronçon 4a, pour accorder leurs indices effectifs. La deuxième contrainte est que le couplage optimal ne peut s'effectuer que sur une distance précise qui est la longueur de battement ou longueur de couplage Lc évoquée précédemment. Si la longueur est inférieure à Lc, le couplage ne sera pas totalement réalisé. Si la longueur est supérieure à Lc, le couplage se fera sur une distance Lc, puis le mode se découplera en partie sur la distance restante (pour une longueur L=2*Lc, le mode revient à son état initial). Ainsi, on aura tendance à utiliser des multiples impairs de Lc supérieurs à 1 pour augmenter la probabilité de couplage optique efficace.

La forme du guide d'onde 2 peut alors être étudiée de manière à obtenir un couplage robuste par rapport aux variations opto-géométriques induites lors de la fabrication. Les transformateurs de mode 8a, 8b sont donc présents d'une part pour pallier aux éventuels défauts de conception, et d'autre part pour assurer un couplage optique optimum sur une longueur, de préférence, simplement égale à la longueur de couplage Lc. Pour former les transformateurs de mode 8a, 8b, la largeur du premier tronçon 4a est inférieure, sur au moins une portion dudit premier tronçon 4a, à la largeur du guide d'onde 2 de part et d'autre du premier tronçon 4a. Le rétrécissement engendré délimite les premier et second transformateurs de mode 8a, 8b. Sur la figure 4, la largeur du guide d'onde est définie par la dimension $d_1$ perpendiculaire à l'axe A1, et comprise dans le plan de la boucle formée par le guide d'onde 2. Autrement dit, dans une section du guide d'onde 2 formée dans le plan du guide d'onde 2, la section comporte un rétrécissement au niveau du premier tronçon 4a.

Dans le cas d'un couplage adiabatique par transformateur de mode la largeur du guide d'onde 2, à une extrémité du transformateur de mode 8a, 8b, est conçue de sorte que l'indice effectif du guide d'onde est inférieur à l'indice effectif de l'amplificateur (qui reste lui invariant selon l'axe de propagation). On applique le raisonnement contraire pour la largeur du guide d'onde à une autre extrémité du transformateur de mode. Ainsi, tout au long du transformateur de mode, l'indice effectif du guide d'onde 2 sera inférieur, égal, et enfin supérieur à l'indice effectif de l'amplificateur 2 ou inversement. On peut par ce biais coupler de manière progressive la puissance optique, et ce de manière réversible guide vers amplificateur, ou amplificateur vers guide.

Un autre avantage des transformateurs de mode 8a, 8b est que le couplage est efficace à partir d'une certaine longueur, et qu'il reste sensiblement identique selon les conceptions au-delà de cette longueur. Un transformateur de mode permet de s'affranchir de la problématique liée à la précision de longueur de couplage (que l'on retrouve dans le cas du couplage directionnel) en utilisant par exemple une longueur simplement supérieure ou égale à Lc pour la zone de couplage optique $Z_1$, $Z_2$ concernée. Ce principe est illustré à la figure 5, en partant de la gauche vers la droite, le guide d'onde 2 à section variable a une forme divergente, selon F (direction de propagation de l'onde optique considérée), correspondant à une variation de sa dimension latérale $d_1$. L'amplificateur 1 disposé au-dessus du guide d'onde 2 est à section constante. Une onde optique est représentée par des pointillés au niveau des coupes (a), (b), (c), perpendiculaires au sens de déplacement F de ladite onde, lesdites coupes étant respectivement indiquées par les flèches $F_{c1}$, $F_{c2}$, $F_{c3}$. L'onde optique est d'abord confinée dans l'amplificateur (a), puis au fur et à mesure que la section du guide d'onde s'élargie (selon $d_1$), les indices effectifs se rapprochent, l'onde est petit à petit couplée au guide d'onde (b) jusqu'à être couplée totalement (c) sur la longueur de couplage Lc (au début l'indice effectif du guide d'onde 2 est inférieur à l'indice effectif de l'amplificateur 1, puis on a un accord de phase avec l'indice effectif du guide d'onde 2 qui est alors égal à l'indice effectif de l'amplificateur 1, puis l'indice effectif du guide d'onde 2 devient supérieur à l'indice effectif de l'amplificateur 1). La structuration adaptée du guide d'onde 2 permet au dispositif laser, par transformation modale, de bénéficier à plein du gain disponible. Ceci est possible car dans une partie centrale du dispositif laser (partie entre les deux transformateurs de mode 8a, 8b), le champ électromagnétique (c'est-à-dire le mode de l'onde optique) est principalement confiné dans la zone active (milieu amplificateur), et le recouvrement avec les puits quantiques est maximal, permettant ainsi de renforcer le gain modal et de réduire le seuil du dispositif laser par rapport à l'art antérieur. Cette transformation modale est alors adiabatique (sans perte d'énergie), et elle garantit un couplage optimal vers un circuit photonique sous-jacent. La figure 5 illustre une onde confinée dans l'amplificateur 1 et se couplant au guide d'onde 2, le fonctionnement inverse étant possible à partir de la même structure (onde confinée dans le guide d'onde et se couplant à l'amplificateur).

De préférence, comme illustré à la figure 6 chaque transformateur de mode 8a, 8b peut comporter une première portion $P_1$ agencée de sorte à limiter les pertes engendrées par les processus de diffraction lors d'un couplage amplificateur 1 vers guide d'onde 2, le processus étant réversible, il se passe la même chose lors du couplage guide d'onde 2 vers amplificateur. Cette première portion $P_1$ peut être divergente (vers la droite de la figure), et sur cette portion $P_1$, la distance séparant deux flancs 9a, 9b du guide d'onde 2 évolue entre $I_1$ et $I_2$ avec, de préférence, $I_1=500nm$ et $I_2=700nm$, sur une longueur $d_2$ de quelques microns (typiquement une dizaine, et de préférence compris entre $2\mu m$ et $20\mu m$). Les flancs 9a, 9b sont, de préférence, formés dans des plans perpendiculaires au plan sur lequel est formée la boucle. Ensuite, le transformateur de mode 8b peut comporter une deuxième portion $P_2$ dite de collection optimisée située à la suite de la première portion $P_1$ selon son sens de divergence. Cette deuxième portion $P_2$ a, de préférence, une longueur sensiblement égale à la longueur de couplage Lc nécessaire pour coupler totalement l'onde optique de l'amplificateur 1 au guide d'onde 2, vice-versa. La deuxième portion $P_2$ est, de préférence, aussi divergente dans le même sens que la première portion $P_1$. Sur cette deuxième portion $P_2$ la plus petite dimension $I_2$ séparant les deux flancs 9a, 9b du guide d'onde 2 peut être de 700nm, alors que la plus grande dimension $I_3$ séparant les deux flancs 9a, 9b peut être de 1100nm. À la suite de la deuxième portion $P_2$, la distance séparant les deux flancs peut augmenter jusqu'à devenir égale à la dimension latérale maximale $I_{max}$ du guide d'onde 2 pour former un guide d'onde 2 à section de forme générale rectangulaire. Selon une variante non

représentée $I_{max}$ peut être égale à $I_3$. Au niveau du guide d'onde, les premières portions $P_1$ des deux transformateurs de mode 8a, 8b sont proximales et divergent dans deux sens opposés sensiblement parallèles à l'axe longitudinal A1 (axe de propagation de l'onde optique). Les transformateurs de mode 8a, 8b sont, de préférence, séparés par une portion 10, de préférence de section constante, au niveau de laquelle la distance séparant les deux flancs 9a, 9b est inférieure ou égale à $I_1$. La largeur de la portion 10 selon le sens de propagation de l'onde optique permet d'interdire, ou de limiter très fortement, tout couplage optique entre le guide d'onde 2 et l'amplificateur de sorte à confiner l'onde dans l'amplificateur au voisinage de la portion 10. Autrement dit, on choisira entre les deux transformateurs de mode 8a, 8b une dimension latérale permettant à l'indice effectif du guide d'être inférieur à l'indice effectif de l'amplificateur pour éviter le couplage optique, typiquement cette distance est inférieure ou égale à 500nm.

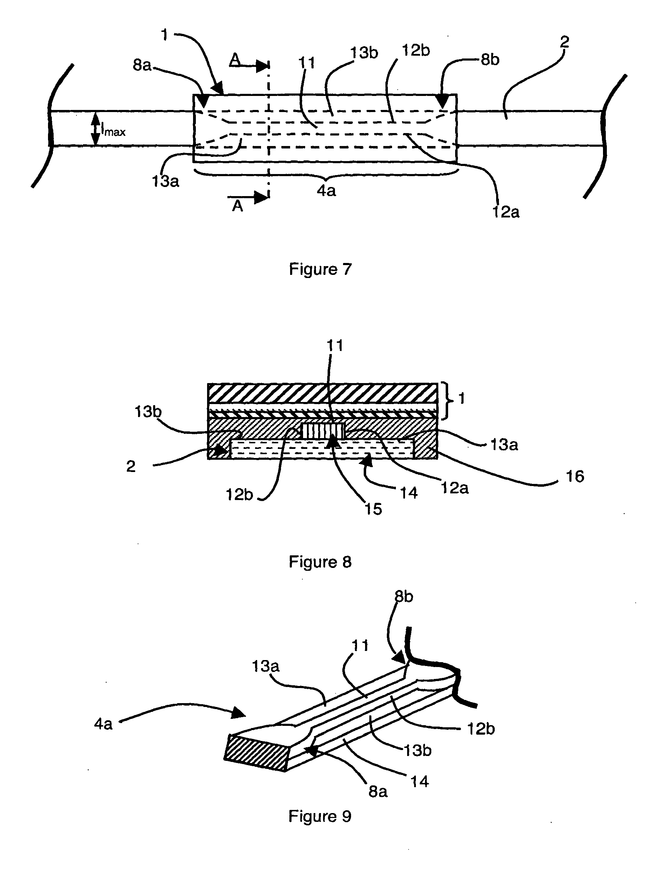

Selon une mise en oeuvre particulière illustrée aux figures 7 à 9, le premier tronçon 4a du guide d'onde 2 comporte, de préférence, au moins une portion dont la section (figure 8), selon une coupe perpendiculaire à la direction de propagation de l'onde optique (coupe A-A de la figure 7), est en forme de créneau dont le sommet 11 est proximal de l'amplificateur 1. Le créneau peut être défini par un sommet 11, des parois latérales 12a, 12b reliant le sommet 11 du créneau au fond 13a, 13b du créneau formé de part et d'autre des parois latérales 12a, 12b. Autrement dit, au moins localement, le guide d'onde 2 peut comporter une base 14 sur laquelle est formée une saillie 15 délimitant avec ladite base 14 le créneau. La saillie 15 permet notamment de délimiter le sommet 11 et les parois latérales 12a, 12b. La base 14 et la saillie 15 formant créneau peuvent être formées d'un même matériau, ou de matériaux distincts. Dans le cas d'utilisation de matériaux distincts, cela permet un avantage au niveau de la fabrication, il est alors possible de faire croître la saillie 15, par exemple en silicium amorphe, destinée à former le créneau sur la base 14, évitant ainsi une étape de gravure supplémentaire. L'utilisation d'un tel guide d'onde permet de former un créneau s'interfaçant avec l'amplificateur, et dont les dimensions latérales au niveau des parois latérales 12a, 12b sont inférieures aux dimensions latérales maximales $I_{max}$ du guide d'onde 2. Ceci permet de favoriser un couplage monomode de l'amplificateur 1 avec le guide d'onde 2, notamment lorsque la distance séparant les parois latérales, au voisinage de l'amplificateur est comprise entre 500nm et 1100nm.

Dans cette mise en oeuvre particulière, les transformateurs de mode 8a, 8b sont formés comme décrits précédemment, à la différence près que la base 14 a des dimensions invariables, et que c'est la variation de la distance séparant les parois latérales 12a, 12b qui forme les transformateurs de mode 8a, 8b (les dimensions s'appliquant aux flancs précédemment décrits s'appliquent donc dans ce mode aux parois latérales).

Le sommet 11 du créneau et les parois latérales 12a, 12b du créneau sont, de préférence, recouverts par une couche d'un matériau diélectrique au voisinage de l'amplificateur. Par voisinage, on entend « au niveau du premier tronçon 4a ».

Cette structure de guide d'onde 2 à créneau est aussi appelée dans le domaine guide arête. Le guide arête au niveau du premier tronçon 4a peut uniquement comporter la base et la saillie formant créneau. Dans le guide arête, l'indice effectif des modes est plus élevé. Il est également plus facile par construction de diminuer le nombre de modes supportés par le guide en diminuant la largeur de l'arête pour favoriser un couplage monomode.

Sur la figure 8, la couche en matériau diélectrique 16 recouvrant le sommet 11 et les parois latérales 12a, 12b du créneau au voisinage de l'amplificateur 1 peut être réalisée en $SiO_2$. Cette couche en matériau diélectrique 16 améliore l'efficacité du dispositif laser en jouant sur les caractéristiques optoélectroniques (notamment les composantes thermiques et optiques) de ce dernier. L'encapsulation du créneau, au moins au niveau de son sommet 11 et de ses parois latérales 12a, 12b, par la couche en matériau diélectrique 16 permet de diminuer les pertes de propagation liées aux rugosités obtenues lors de la structuration du créneau. En effet, plus les surfaces extérieures du guide d'onde 2 sont rugueuses, plus l'onde optique se propageant dans le guide d'onde 2, notamment lors du couplage optique entre le guide d'onde 2 et l'amplificateur 1, risque de diffuser hors du guide d'onde 2, limitant ainsi l'efficacité du dispositif laser. La couche en matériau diélectrique 16 permet alors, en diminuant le contraste d'indice de réfraction et en comblant les aspérités du guide d'onde 2, de limiter les effets de diffusion. La couche en matériau diélectrique 16 permet aussi d'améliorer l'efficacité du dispositif laser car elle joue un rôle de conducteur thermique, permettant de diffuser, hors de la zone de gain (zone comportant les puits quantiques), une partie de la chaleur générée par le dispositif laser lors de son fonctionnement. Ainsi, on choisira, de préférence, un matériau bon conducteur thermique. La réduction de ces deux effets néfastes au dispositif laser permet de manière synergique d'améliorer grandement l'efficacité du dispositif laser. Les matériaux tels que $SiO_2$, $Al_2O_3$, $TiO_2$, SiON, $HfO_2$, $Si_3N_4$, en tant que couche en matériau diélectrique 16, sont des candidats particulièrement pertinents pour réduire ces effets thermiques et optiques. De préférence, tout le guide d'onde 2, porté typiquement par un substrat de support, est recouvert par la couche en matériau diélectrique 16. Autrement dit, selon un perfectionnement, le fond de créneau est aussi recouvert par la couche en matériau diélectrique 16. Ce principe peut s'appliquer aussi au guide d'onde 2 des figures 2 à 4 et 6, le guide d'onde est alors aussi recouvert par le matériau diélectrique.

De préférence, le guide d'onde 2 est à base de silicium comme, par exemple, du silicium cristallin, amorphe ou même dopé. Si l'on souhaite fonctionnaliser le guide d'onde 2, le silicium sera dopé pour ajouter une nouvelle fonction optique. De manière générale, on peut aussi utiliser des matériaux à moyen indice de réfraction comme, par exemple, les composés nitrurés tels que le $Si_3N_4$, SiON, ou encore $Al_2O_3$. En fait, le silicium a un indice de réfraction situé autour de 3,5, et la silice un indice de réfraction compris entre 1,4 et 1,5, ainsi par indice moyen de réfraction, on entend un indice de réfraction compris, de préférence, entre 1,8 et 3. Dans le cas où la base 14 et la saillie 15 sont en matériaux distincts, la base 14 peut être en silicium et, de préférence, la saillie 15 est en composé nitruré.

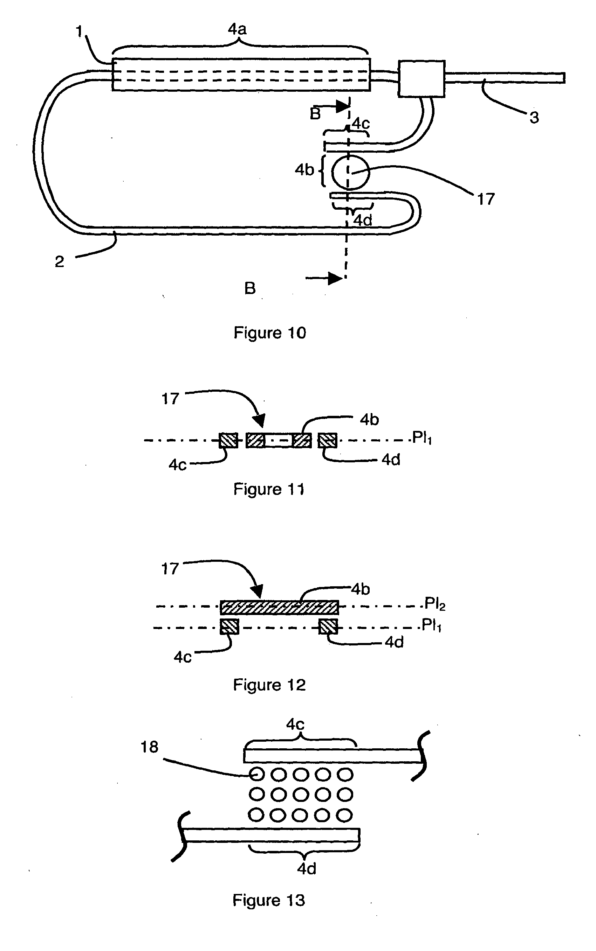

Comme sur la figure 10, une des fonctionnalités qui peut être rajoutée au dispositif laser est un micro-résonateur 17, pour réaliser un filtrage de mode de l'onde optique, formé au niveau d'un deuxième tronçon 4b du guide d'onde 2, distinct du premier tronçon 4a. Le but du micro-résonateur 17 est de favoriser, de préférence, un seul mode optique constituée par des photons générés par l'amplificateur 1. Il joue alors un rôle de filtre apte à exacerber un mode particulier de la cavité laser circulaire. Le micro-résonateur 17 est donc disposé entre des troisième 4c et quatrième 4d tronçons, et est couplé optiquement à ces troisième et quatrième tronçons 4c, 4d de sorte à laisser passer au moins un mode optique considéré. Les tronçons sont agencés de sorte à être compatible avec le sens de propagation des photons et permettre leurs passage d'un tronçon à l'autre. Afin d'exacerber un mode particulier, il est possible de dimensionner le micro-résonateur 17 par rapport aux troisième et quatrième tronçons 4c, 4d afin que le résonateur 17 ait un indice effectif différent de celui des troisième et quatrième tronçons 4c, 4d. L'homme du métier pourra adapter ces indices effectifs à sa convenance en fonction du mode de l'onde optique qu'il cherchera à exacerber en fonction du cahier des charges du dispositif laser.

Ce dimensionnement peut être réalisé lors de la conception du dispositif. Cependant cette solution implique que le dispositif sera cantonné à exacerber toujours le même mode. Ainsi, dans certaines applications, on peut par exemple chercher à ajuster les longueurs d'onde, il résulte alors un besoin d'adapter le dispositif afin de pouvoir exacerber le mode de son choix. Pour répondre à ce besoin, le micro-résonateur peut comporter un système de modulation de son indice effectif. Le micro-résonnateur peut être dopé et son indice effectif peut varier par exemple par injection ou déplétion de porteur. Un tel système de modulation peut être mis en oeuvre en formant un micro-résonateur 17 à base de silicium dopé de type P et N. Ensuite, en formant des électrodes respectivement associées au dopage P et au dopage N, il est possible, en polarisant ces électrodes, de faire varier l'indice effectif du micro-résonateur 17 en altérant ce dernier. En faisant varier l'indice effectif du micro-résonateur 17, on change les propriétés du couplage optique de ce dernier avec les troisième et quatrième tronçons 4c, 4d.

Selon une mise en oeuvre particulière illustrée aux figures 10 à 12, le deuxième tronçon 4b du guide d'onde 2 a la forme d'un anneau ou d'un disque couplé respectivement à des troisième et quatrième tronçons 4c, 4d du guide d'onde 2 distincts du premier tronçon 4a. Les troisième et quatrième tronçons sont, de préférence, parallèles. En fonction des utilisations, l'homme du métier choisira la structure adaptée (disque/anneau), bien que le micro disque soit plus facile à mettre en oeuvre au niveau de la fabrication). Selon une mise en oeuvre particulière du micro-résonateur 17, les deuxième, troisième et quatrième tronçons 4b, 4c, 4d sont formés dans un même plan $Pl_1$ (figure 11). Selon une variante les troisième et quatrième tronçons 4c, 4d sont formés dans un même plan $Pl_1$, parallèle à un plan $Pl_2$ décalé et comportant le deuxième tronçon 4b (figure 12). Les figures 11 et 12 représentent deux variantes selon une vue en coupe B-B de la figure 10. Le deuxième tronçon 4b comporte alors des portions respectivement en regard des troisième et quatrième tronçons 4c, 4d de sorte à réaliser le couplage optique du résonateur avec les troisième et quatrième tronçons 4c, 4d (sur la figure 12, ces portions sont disposées au-dessus des troisième et quatrième tronçons 4a, 4d).

Dans le cas où les deuxième, troisième et quatrième tronçons 4b, 4c, 4d sont formés dans un même plan, ces derniers sont, de préférence, formés à base de silicium.

Dans le cas où les troisième et quatrième tronçons 4c, 4d sont formés dans un même plan parallèle à un plan décalé comportant le deuxième tronçon 4b (figure 12). Les troisième et quatrième tronçons 4c, 4d sont, de préférence, réalisés à base de silicium, et le deuxième tronçon 4b formant micro-résonateur 17 est formé de la même manière que l'hétérostructure de type III-V. Le micro-résonateur 17 est, préférentiellement, formé dans le même plan que l'amplificateur 1 pour être réalisé lors de mêmes étapes de fabrication. L'avantage du micro-résonateur 17 de type III-V est de permettre d'améliorer le gain. De plus, selon l'application, il est possible d'appliquer une tension au niveau du matériau III-V du micro-résonateur 17 de sorte à absorber les photons. L'absorption de photons permet avantageusement le codage ultra-rapide de l'information. Il est ainsi possible de réaliser des dispositifs lasers avec une modulation intra-cavité.

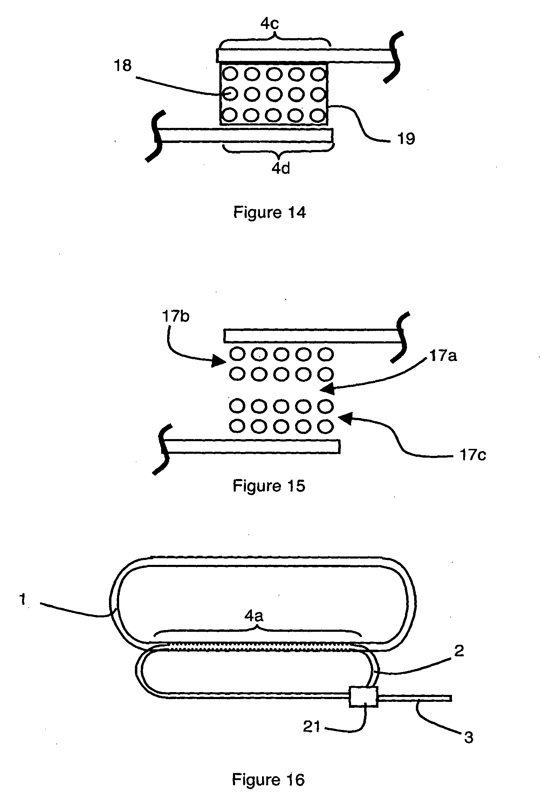

Selon une autre mise en oeuvre, le micro-résonateur 17 est un cristal photonique. Un cristal photonique peut être obtenu en structurant un tronçon plein, par exemple en silicium. Les figures 13 et 14 illustrent une structuration sous la forme de barres 18, de préférence sensiblement perpendiculaires au plan dans lequel le guide d'onde est formé. Ces barres 18 peuvent être obtenues à partir d'un bloc partiellement (figure 14) ou totalement (figure 13) gravé. Dans le cas où le bloc est totalement gravé, les barres 18 sont séparées les unes des autres sur toute l'épaisseur du deuxième tronçon 4b, et dans le cas où le bloc est partiellement gravé, les barres 18 sont reliées par une embase 19 formée dans le même matériau que lesdites barres, les barres 18 et l'embase 19 étant monobloc. Le micro-résonateur 17 des figures 13 et 14 est couplé optiquement aux troisième et quatrième tronçons 4c, 4d.

Selon une variante illustrée à la figure 15, il est possible d'ajouter dans le cristal photonique une zone libre apte à accumuler l'onde optique avant de la renvoyer respectivement dans les troisième et quatrième tronçons 4c, 4d. Sur la figure 15, la zone libre 17a du résonateur 17 située entre deux réseaux 17b, 17c de cristaux photoniques. Cette zone libre 17a peut être formée par l'omission d'une ligne de barre.

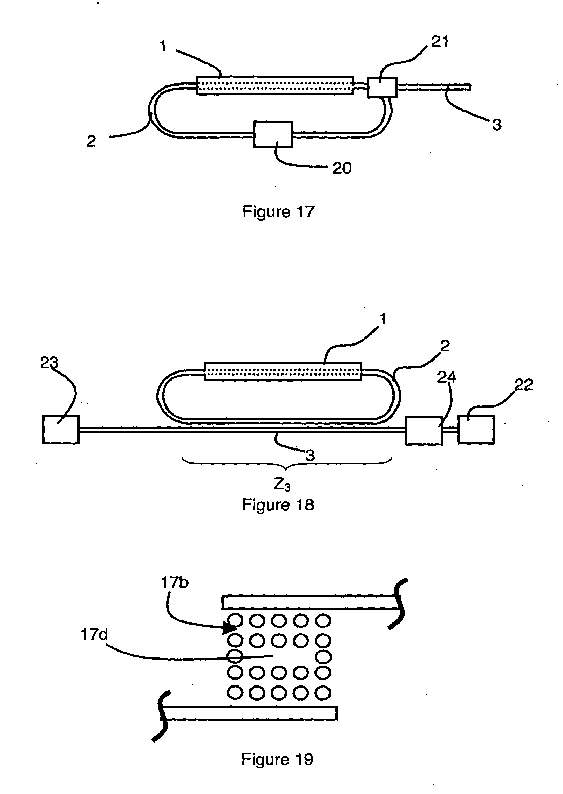

Une variante de la figure 15 est illustrée à la figure 19. Dans cette variante, le cristal photonique comporte une cavité 17d située au milieu des cristaux photoniques 17b.

Le micro-résonateur décrit ci-dessus permet notamment de réaliser un filtrage du mode et d'augmenter le facteur de qualité. Il permet aussi selon les applications de réaliser un dispositif laser monomode. Le micro-résonateur a préférentiellement des dimensions de l'ordre de $20\mu m$ à $30\mu m$.

Les barres des cristaux photoniques peuvent être agencées par mailles carrées, triangulaires, etc. Sur les figures 13 à 15, les barres sont agencées sous la forme de mailles carrées, c'est-à-dire sous la forme d'une matrice de lignes et de colonnes. Les lignes sont alors orientées dans le sens des troisième et quatrième tronçons 4c, 4d. Une zone libre peut être formée par l'omission d'une ligne (figure 15) ou d'une partie d'une ligne (figure 19). Selon une variante, deux lignes adjacentes seront formées que sorte à placer les barres des deux lignes en quinconce.

Bien que les cristaux photoniques aient été définis ci-dessus comme des barres ou des barres associées à une embase, ils peuvent aussi être réalisés par des trous débouchant ou non par exemple formés dans un tronçon plein en silicium.

Sur la figure 16 illustrant une variante de mise en oeuvre applicable en combinaison avec les caractéristiques décrites ci-dessus, l'amplificateur 1 a une forme de boucle, une seule portion de la boucle de l'amplificateur 1 étant disposée en regard du premier tronçon 4a du guide d'onde 2. Sur la figure 16, la boucle associée au guide d'onde 2 et la boucle associée à l'amplificateur 1 sont formées dans les plans sensiblement parallèles, et décalés de sorte à obtenir un recouvrement partiel du guide d'onde 2 et de l'amplificateur 1. Ceci permet à la portion de boucle de l'amplificateur 1 de réaliser le couplage optique avec le guide d'onde 2 au niveau du premier tronçon 4a, tout en conservant un amplificateur performant en puissance du fait de sa longueur et de sa forme en boucle. La forme de boucle de l'amplificateur permet un effet Vernier, c'est-à-dire de faire coïncider les modes de deux ondes afin de réaliser un dispositif laser monomode. Afin d'exacerber un seul mode de l'onde optique, les boucles peuvent avoir un indice effectif identique et une longueur différente, ou une longueur identique avec un indice effectif différent.

Selon une autre fonctionnalisation illustrée à la figure 17, il est possible de rajouter sur un tronçon disponible (distinct du tronçon 4a) du guide d'onde 2 un amplificateur optique à semi-conducteur 20 couplé optiquement au guide d'onde 2. Un tel amplificateur optique à semi-conducteur 20 (SOA pour « semiconductor optical amplifier » en anglais) peut être de longueur inférieure à l'amplificateur 1 car son unique but est d'amplifier le signal de l'onde, et que pour ce faire il ne nécessite qu'un simple pompage électrique. Un tel amplificateur optique à semi-conducteur 20 permet également de moduler, c'est-à-dire coder de l'information par exemple par électroabsorption en appliquant une tension de commande au SOA et en la faisant varier. Il peut être couplé au guide d'onde 2 en utilisant des transformateurs de mode qui lui sont associés à la manière de ceux de l'amplificateur 1 destiné à générer les photons. Le tronçon du guide d'onde 2 couplé à l'amplificateur optique à semi-conducteur 20 peut aussi avoir une section en forme de créneau tel que décrit précédemment. Le SOA 20 peut être formé par un empilement identique à celui de l'amplificateur 1. L'utilisation d'un SOA ne se limite pas au mode de réalisation de la figure 17, le SOA peut en effet être utilisé dans tous les modes de réalisations et variantes décrits ci-dessus et ci-dessous.

Comme illustré aux figures 2, 10, 16, 17, le guide d'onde 2 en forme de boucle peut être couplé à un guide d'onde de sortie 3 pour extraire une partie de l'onde optique se propageant dans le guide d'onde 2 sous la forme d'une onde laser. L'onde laser peut alors ensuite être transférée via le guide d'onde de sortie 3 à un dispositif apte à l'exploiter, par exemple à une fibre optique permettant d'amener l'onde laser à un dispositif distant associé.

Sur les figures 2, 10, 16, 17, l'onde laser est extraite de la boucle du guide d'onde 2 par un diviseur 21 de faisceau relié au guide d'onde de sortie 3. Sur la figure 2, le diviseur 21 est illustré en détail. Il s'agit en fait d'un MMI « pour « multimode interferometer » en anglais). Un MMI permet de diviser un faisceau d'entrée vers N faisceaux de sortie. Les MMI utilisés peuvent être du type de ceux décrits dans la publication « Optical Multi-Mode Interference Devices Based on Self-Imaging : Principles and Application » de Lucas B. Soldano et al publié dans le « Journal of Lightwave Technology vol. 13 no 4 » d'avril 1995 pages 615 à 627. Pour des raisons de clarté sur les autres figures 10, 16, 17 la référence 21 est simplement représentée par un bloc, même si il s'agit d'un MMI.

Selon une variante du diviseur 21 de faisceau applicable aux différentes réalisation et illustrée à la figure 18, le guide d'onde de sortie 3 et le guide d'onde 2 en forme de boucle sont formés dans un même plan, et sont séparés par une distance idoine permettant leur couplage optique au niveau de deux tronçons sensiblement parallèles. Cette distance idoine permet de fixer le taux de couplage, c'est-à-dire la puissance prélevée à chaque tour du photon, et donc le facteur de qualité de l'ensemble. Ce diviseur peut être appliqué à tous les modes de réalisation à la place du MMI.

Le guide d'onde 2 et l'amplificateur 1 peuvent être réalisés sur des substrats différents. Les substrats sont ensuite collés l'un à l'autre, par exemple par collage moléculaire. De préférence, le guide d'onde est formé sur un substrat de type SOI.

Les différents dimensionnements du guide d'onde 2 et de l'amplificateur 1 peuvent être obtenus par des méthodes de simulation utilisant, par exemple, la suite logicielle RSOFT©. Par exemple, pour calculer les modes propres et les constantes de propagation, ou de manière équivalente les indices effectifs associés, il pourra être utilisé la méthode des éléments finis du module FEMSIM de RSOFT©. L'efficacité du couplage peut être calculée en utilisant la méthode de propagation des faisceaux (BPM pour « Beam Propagation Method » en anglais) telle que définie dans le module BeamProp de RSOFT©.

Selon une variante illustrée à la figure 18, le guide d'onde de sortie 3 comporte un réseau 22 nanostructuré de sortie apte à être couplé avec une fibre optique (non représentée). Ce réseau 22 peut être formé par des tranchées formées dans le guide d'onde de sortie perpendiculairement à la direction de propagation de l'onde, autrement dit perpendiculairement à l'axe longitudinal du guide d'onde de sortie 3. Pour définir le réseau 22, il peut être utilisé la méthode temporelle des différences finies FDTD (pour « Finite-Difference Time-Domain Method » en anglais) du module Fullwave de RSOFT©.

Le guide d'onde de sortie 3 peut aussi comporter une photodiode 23 de contrôle permettant de mesurer l'onde laser incidente. Sur la figure 18, cette photodiode 23 est opposée au réseau 22.

Le guide d'onde de sortie 3 peut en outre comporter un modulateur 24 pour coder une information agencé entre une zone de couplage $Z_3$, entre le guide d'onde 3 et le guide d'onde 2, et la sortie du dispositif laser (avant le réseau 22 sur la figure 18). Un tel modulateur 24 peut, par exemple, être de type électro-absorption ou de Mach Zehnder. Le modulateur peut comporter des matériaux de type III-V et/ou de silicium.

Le modulateur 24 et le réseau 22 peuvent être mis en oeuvre à la sortie du MMI.

Le dispositif laser tel que décrit permet d'intégrer sur une même puce des fonctions complexes de gestion de faisceaux optiques comme le multiplexage, le démultiplexage, la modulation, le routage spectral, etc. Ces fonctions peuvent être dédiées à des liaisons optiques très courtes distances (à l'échelle du millimètre), ou des liaisons optiques longues distances, de l'ordre de plusieurs kilomètres. Ces fonctions optiques peuvent solutionner les problématiques liées à l'augmentation du débit de bus d'interconnexion.

## Revendications

1. Dispositif laser comportant :

   - un amplificateur (1) comprenant une hétérostructure de type III-V agencée pour générer des photons,
   - un guide d'onde (2) à base de silicium, formant une boucle, couplé optiquement à l'amplificateur (1) disposé en regard du guide d'onde (2) uniquement au niveau d'un premier tronçon (4a) dudit guide d'onde (2),
   **caractérisé en ce qu'**il comporte un premier transformateur de mode (8a) et un second transformateur de mode (8b), chacun formé dans le guide d'onde (2) à une extrémité respective du premier tronçon (4a) de sorte à réaliser le couplage optique entre le guide d'onde (2) et l'amplificateur (1), la largeur du premier tronçon (4a) étant inférieure, sur au moins une portion de ce dernier, à la largeur dudit guide d'onde (2) de part et d'autre dudit premier tronçon (4a) engendrant ainsi un rétrécissement, ledit rétrécissement délimitant les premier et second transformateurs de mode (8a,8b).

2. Dispositif selon la revendication 1, **caractérisé en ce que** l'amplificateur (1) a une forme de boucle, une seule portion de la boucle de l'amplificateur (1) étant disposée en regard du premier tronçon (4a) du guide d'onde (2).

3. Dispositif selon l'une des revendications 1 et 2, **caractérisé en ce que** le guide d'onde (2) comporte un deuxième tronçon (4b) distinct du premier tronçon (4a), et formant un micro-résonateur (17) pour réaliser un filtrage de mode.

4. Dispositif selon la revendication 3, **caractérisé en ce que** le micro-résonateur 17 comporte un système de modulation de son indice effectif.

5. Dispositif selon la revendication 3, **caractérisé en ce que** le deuxième tronçon (4b) a la forme d'un anneau ou d'un disque couplé optiquement à des troisième et quatrième tronçons (4c, 4d) du guide d'onde (2) distincts du premier tronçon (4a).

6. Dispositif selon la revendication 5, **caractérisé en ce que** les deuxième, troisième et quatrième tronçons (4b, 4c, 4d) sont formés dans un même plan (Pl$_1$).

7. Dispositif selon la revendication 5, **caractérisé en ce que** les troisième et quatrième tronçons (4c, 4d) sont formés dans un même plan (Pl$_1$), parallèle à un plan (Pl$_2$) décalé comportant le deuxième tronçon (4b).

8. Dispositif selon la revendication 3, **caractérisé en ce que** le micro-résonateur (17) est un cristal photonique.

9. Dispositif selon l'une quelconque des revendications précédentes, **caractérisé en ce que** le guide d'onde (2) est couplé à un amplificateur optique à semi-conducteur sur un tronçon du guide d'onde (2) distinct du premier tronçon (4a).

## Patentansprüche

1. Laservorrichtung umfassend:

   - einen Verstärker (1) mit einer Heterostruktur vom Typ III-V, die dazu eingerichtet ist, Photonen zu erzeugen,
   - einen eine Schleife bildenden Wellenleiter (2) auf Siliziumbasis, der mit dem Verstärker (1), welcher lediglich im Bereich eines ersten Abschnitts (4a) des Wellenleiters (2) gegenüber dem Wellenleiter (2) angeordnet ist, optisch gekoppelt ist,
   **dadurch gekennzeichnet, dass** sie einen ersten Modenwandler (8a) und einen zweiten Modenwandler (8b) umfasst, die jeweils in dem Wellenleiter (2) an einem jeweiligen Ende des ersten Abschnitts (4a) gebildet sind, um die optische Kopplung zwischen dem Wellenleiter (2) und dem Verstärker (1) herzustellen, wobei die Breite des ersten Abschnitts (4a) über wenigstens einen Teil dieses letzteren kleiner ist als die Breite des Wellenleiters (2) auf beiden Seiten des ersten Abschnitts (4a), wodurch eine Verjüngung erzeugt wird, wobei die Verjüngung den ersten und den zweiten Modenwandler (8a, 8b) begrenzt.

2. Vorrichtung nach Anspruch 1, **dadurch gekennzeichnet, dass** der Verstärker (1) eine Schleifenform aufweist, wobei ein einziger Teil der Schleife des Verstärkers (1) gegenüber dem ersten Abschnitt (4a) des Wellenleiters (2) angeordnet ist.

3. Vorrichtung nach einem der Ansprüche 1 und 2, **dadurch gekennzeichnet, dass** der Wellenleiter (2) einen zweiten Abschnitt (4b) umfasst, der von dem ersten Abschnitt (4a) getrennt ist und einen Mikroresonator (17) für die Durchführung einer Modenfilterung bildet.

4. Vorrichtung nach Anspruch 3, **dadurch gekennzeichnet, dass** der Mikroresonator (17) ein System zur Modulation seines effektiven Index umfasst.

5. Vorrichtung nach Anspruch 3, **dadurch gekennzeichnet, dass** der zweite Abschnitt (4b) die Form eines Rings oder einer Scheibe aufweist, der/die mit einem dritten und einem vierten Abschnitt (4c, 4d) des Wellenleiters (2), welche von dem ersten Abschnitt (4a) getrennt sind, optisch gekoppelt ist.

6. Vorrichtung nach Anspruch 5, **dadurch gekennzeichnet, dass** der zweite, der dritte und der vierte Abschnitt (4b, 4c, 4d) in einer gleichen Ebene ($Pl_1$) gebildet sind.

7. Vorrichtung nach Anspruch 5, **dadurch gekennzeichnet, dass** der dritte und der vierte Abschnitt (4c, 4d) in einer gleichen Ebene ($Pl_1$), welche zu einer den zweiten Abschnitt (4b) umfassenden versetzten Ebene ($Pl_2$) parallel verläuft, gebildet sind.

8. Vorrichtung nach Anspruch 3, **dadurch gekennzeichnet, dass** der Mikroresonator (17) ein photonischer Kristall ist.

9. Vorrichtung nach einem der vorhergehenden Ansprüche, **dadurch gekennzeichnet, dass** der Wellenleiter (2) mit einem optischen Halbleiterverstärker über einen von dem ersten Abschnitt (4a) getrennten Abschnitt des Wellenleiters (2) gekoppelt ist.

**Claims**

1. A laser device comprising:

   - an amplifier (1) comprising a III-V heterostructure arranged to generate photons,
   - a silicon-based waveguide (2) forming a loop and optically coupled to the amplifier (1) arranged facing the waveguide (2) only in the region of a first section (4a) of said waveguide (2), **characterized in that** it comprises a first mode transformer (8a) and a second mode transformer (8b), each formed in the waveguide (2) at a respective end of the first section (4a) so as to perform optic coupling between the waveguide (2) and amplifier (1), the width of the first section (4a) being smaller, at least over a portion of the latter, than the width of said waveguide (2) on each side of said first section (4a) so as to generate a contraction, the generated contraction delineating the first and second mode transformers (8a,8b).

2. The device according to claim 1, **characterized in that** the amplifier (1) is in the form of a loop, a single portion of the loop of the amplifier (1) being arranged facing the first section (4a) of the waveguide (2).

3. The device according to one of claims 1 and 2, **characterized in that** the waveguide (2) comprises a second section (4b) distinct from the first section (4a) and forming a microresonator (17) to perform mode filtering.

4. The device according to claim 3, **characterized in that** the microresonator (17) comprises a modulation system of its effective index.

5. The device according to claim 3, **characterized in that** the second section (4b) is in the form of a ring or of a disk optically coupled to third and fourth sections (4c, 4d) of the waveguide (2) distinct from the first section (4a).

6. The device according to claim 5, **characterized in that** the second, third and fourth sections (4b, 4c, 4d) are formed in the same plane ($Pl_1$).

7. The device according to claim 5, **characterized in that** the third and fourth sections (4c, 4d) are formed in the same plane ($Pl_1$), parallel to an offset plane ($Pl_2$) comprising the second section (4b).

8. The device according to claim 3, **characterized in that** the microresonator (17) is a photonic crystal.

9. The device according to any one of the foregoing claims, **characterized in that** the waveguide (2) is coupled with a semiconductor optical amplifier over a section of the waveguide (2) different from the first section (4a).

Figure 1 (Art antérieur)

Figure 2

Figure 3

Figure 4

Figure 5

Figure 6

Figure 7

Figure 8

Figure 9

Figure 10

Figure 11

Figure 12

Figure 13

4c

18

19

4d

Figure 14

17b

17a

17c

Figure 15

1

4a

2

21

3

Figure 16

Figure 17

Figure 18

Figure 19

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 2009028492 A

**Littérature non-brevet citée dans la description**

- **ALEXANDER W. FANG.** Integrated AlGaInAs-silicon evanescent race track Laser and photodectector. *Optic Express,* 05 Mars 2007, vol. 15 (5), 2315-2322

- **LUCAS B. SOLDANO et al.** Optical Multi-Mode Interference Devices Based on Self-Imaging : Principles and Application. *Journal of Lightwave Technology,* Avril 1995, vol. 13 (4), 615-627